# EUROPÄISCHE PATENTSCHRIFT

(11) **EP 0 451 532 B1**
(45) Veröffentlichungstag und Bekanntmachung des Hinweises auf die Patenterteilung: **04.05.1994**
(21) Anmeldenummer: 91103901.4
(22) Anmeldetag: 14.03.1991
(51) Int. Cl.: C04B 35/00, C01G 29/00, H01L 39/24

(54) **Verfahren zur Herstellung eines Hochtemperatursupraleiters**
Process for producing a high temperature superconductor
Procédé d'élaboration d'un supraconducteur haute température

(30) Priorität: 11.04.1990 DE 4011725
(43) Veröffentlichungstag der Anmeldung: 16.10.1991
(73) Patentinhaber: HOECHST AKTIENGESELLSCHAFT, 65926 Frankfurt am Main (DE)
(72) Erfinder: Bock, Joachim, Dr., W-5042 Erftstadt (DE); Preisler, Eberhard, Dr., W-5042 Erftstadt (DE)

(56) Entgegenhaltungen:
- DE-A- 3 707 615
- WORLD PATENT INDEX LATEST, Woche 13, Accession Nr. 89-096338, Derwent Publications Ltd, London, GB; && JP-A-1 043 921 (HITACHI K.K.) 16-02-1989

## Beschreibung

Die vorliegende Erfindung betrifft ein Verfahren zur Herstellung eines Hochtemperatursupraleiters der Zusammensetzung Bi₍₂₊ₐ₎(Sr_{(1-b)}Ca_{b})₍₃₋ₐ₎Cu_{(2+c)}O₍₈₊ₓ₎, wobei a von 0 bis 0,3, b von 0,1 bis 0,9 und c von 0 bis 2 betragen und x einen vom Oxidationszustand der enthaltenen Metalle abhängigen Wert hat, durch intensives Mischen der Oxide und/oder Carbonate des Bismuts, Strontiums, Calciums und Kupfers und Erhitzen dieses Gemisches.

Im allgemeinen erfolgt die Herstellung von keramischen Hochtemperatursupraleitern durch Feststoffreaktion von Gemischen von Metalloxiden oder -carbonaten der Oxidsysteme Y-Ba-Cu-O, Bi-Sr-Ca-Cu-O oder Tl-Ba-Ca-Cu-O. Dazu werden die Gemische mehrmals kurz unterhalb ihres Schmelzpunktes in Luft geglüht oder gesintert, wobei das Gemisch zwischen den einzelnen Glühungen bzw. Sinterungen jeweils durch Mahlen homogenisiert wird. Im System Bi-Sr-Ca-Cu-O ist aber auch auf diese Weise die sog. Zweischichtverbindung Bi₂ (SrCa) ₃Cu₂O₈₊ₓ nicht phasenrein herstellbar; auch CuO-Überschuß im Gemisch der Metalloxide bzw. -carbonate liefert keine phasenreine Verbindung.

Aus der DE-OS 38 30 092 ist ein Verfahren zur Herstellung eines Hochtemperatursupraleiters der Zusammensetzung Bi₂(Sr,Ca)₃Cu₂Oₓ mit Werten für x von 8 bis 10 bekannt. Dabei werden stöchiometrische Mischungen der Oxide oder Carbonate von Bismut, Strontium, Calcium und Kupfer auf Temperaturen von 870 bis 1100°C unter Bildung einer homogenen, ein Sauerstoffdefizit aufweisenden Schmelze erhitzt. Diese Schmelze wird in Kokillen vergossen und erstarrt darin. Die aus den Kokillen entnommenen Gußkörper werden 6 bis 30 Stunden lang bei 780 bis 850°C getempert und anschließend zur Beseitigung des Sauerstoffdefizits mindestens 6 Stunden bei 600 bis 830°C in Sauerstoffatmosphäre behandelt. Auf diese Weise lassen sich Plättchen bis zu mehreren cm Kantenlänge bzw. Durchmesser sowie Stäbe bis zu 50 cm Länge und 10 mm Durchmesser herstellen, welche jeweils aus der phasenreinen Verbindung bestehen.

Für bestimmte Anwendungen wird supraleitendes Material in Form von Pulvern benötigt. Daher ist es Aufgabe der vorliegenden Erfindung, ein Verfahren anzugeben, welches die Herstellung von pulverförmigen Hochtemperatursupraleitern aus Gemischen der Oxide oder Carbonate des Bismuts, Strontiums, Calciums und Kupfers auf direktem Weg und möglichst phasenrein erlaubt. Das wird erfindungsgemäß dadurch erreicht, daß man die Kupferverbindung als Mischung aus Kupfer(I)oxid und Kupfer(II)oxid einsetzt; daß man das Gemisch zunächst in Inertgasatmosphäre bei Temperaturen von 700 bis 800°C 0,5 bis 36 Stunden miteinander reagieren läßt; und daß man anschließend in sauerstoffhaltiger Atmosphäre bei Temperaturen von 700 bis 875°C 3 bis 60 Stunden behandelt.

Das Verfahren gemäß der Erfindung kann weiterhin wahlweise auch noch dadurch ausgestaltet sein, daß
a) das Gewichtsverhältnis von Kupfer im Kupfer(I)oxid zu Kupfer im Kupfer(II)oxid (0,25 : 1,75) bis (1,75 : 0,25) , vorzugsweise (0,5 : 1,5) bis (1,5 : 0,5), beträgt;
b) man das Gemisch in Inertgasatmosphäre bei Temperaturen von 750 bis 780°C miteinander reagieren läßt;
c) man das Gemisch in Inertgasatmosphäre 12 bis 24 Stunden miteinander reagieren läßt;
d) als Inertgas Argon und/oder Stickstoff verwendet ist;
e) man in sauerstoffhaltiger Atmosphäre bei Temperaturen von 810 bis 860°C behandelt;
f) als sauerstoffhaltige Atmosphäre Luft dient.

Beim erfindungsgemäßen Verfahren ist offenbar ein Sauerstoffdefizit zu Beginn der Umsetzung des Gemisches der Oxide oder Carbonate für einen schnellen und vollständigen Gesamtumsatz von entscheidender Bedeutung.

Beim Verfahren gemäß der Erfindung wird durch die Reaktion zwischen dem Kupfer(I)oxid und den weiteren Metallkomponenten bei 700 bis 800°C die gewünschte supraleitende Phase vorgebildet, während bei der anschließenden Behandlung in sauerstoffhaltiger Atmosphäre die Reaktion zu Ende geführt und der zum Erhalt der supraleitenden Phase erforderliche Sauerstoffgehalt der Verbindung eingestellt wird. Dabei ist es vorteilhaft, wenn die Temperatur der Behandlung in sauerstoffhaltiger Atmosphäre höher ist als bei der Reaktion in Inertgasatmosphäre.

Beim erfindungsgemäßen Verfahren kann die sauerstoffhaltige Atmosphäre einen höheren Sauerstoffpartialdruck aufweisen als Luft; sie kann beispielsweise aus reinem Sauerstoff bestehen. Im zuletzt genannten Fall ist jedoch darauf zu achten, daß die Verbindungen nicht zu stark oxidiert werden, d.h. keinen zu hohen Sauerstoffindex aufweisen, da dies zu einer Degradation ihrer supraleitenden Eigenschaften führt.

Beim Verfahren gemäß der Erfindung ist es entscheidend, daß der erste Teil der Reaktion des Gemisches der Oxide bzw. Carbonate unter Inertgasatmosphäre durchgeführt wird, weil Cu₂O bei den in Betracht kommenden Temperaturen in Gegenwart von Sauerstoff im Hinblick auf die Umsetzung zu CuO instabil und daher besonders reaktiv ist.

Bei erfindungsgemäßen Verfahren wird durch die Inertgasatmosphäre während des ersten Teiles der Reaktion die erhöhte Reaktivität des Cu₂O für Ausbildung der Zweischichtverbindung genutzt und die bei Sauerstoffanwesenheit parallel ablaufende Konkurrenzreaktion zu CuO verhindert.

Beim Verfahren gemäß der Erfindung läuft die Bildung der supraleitenden Phase nur dann mit hinreichender Geschwindigkeit ab, wenn eine Mischung aus Kupfer(I)oxid und Kupfer(II)oxid eingesetzt wird, welche mindestens 12,5 Gewichts% Kupfer als Kupfer(II)oxid enthält.

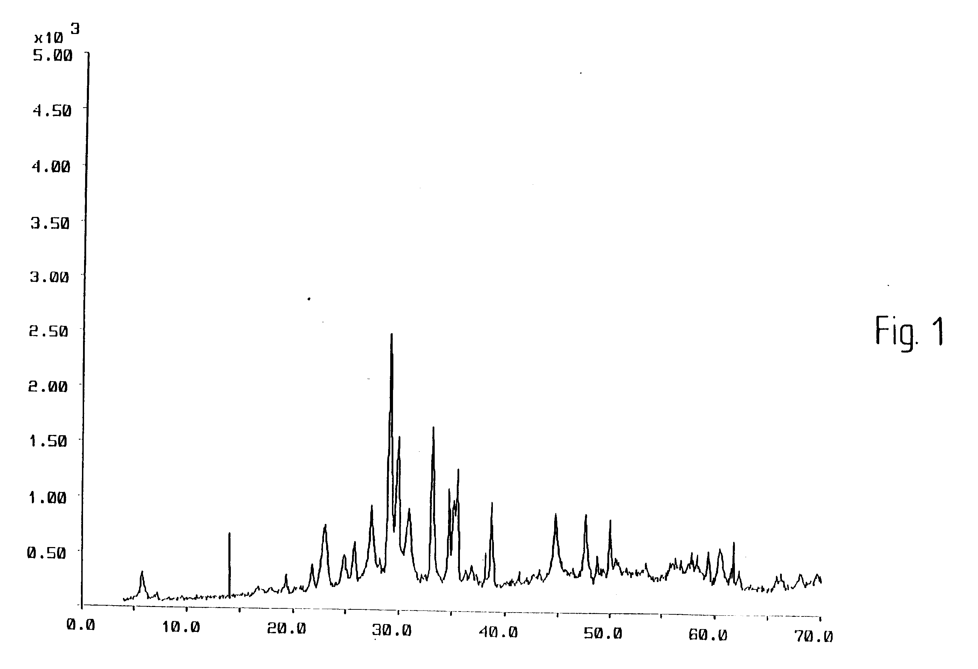

Zu den Röntgenaufnahmen, deren Diagramme in den Figuren 1 bis 4 wiedergegeben sind, wurde Cu_{K_{α}} -Strahlung verwendet. Bei den Röntgendiagrammen, auf welche in den folgenden Beispielen verwiesen wird, ist jeweils auf der Abszisse der Beugungswinkel 2 ϑ aufgetragen, während die Werte auf der Ordinate die Intensität wiedergeben.

### Beispiel 1 (Vergleich)

Eine intensiv homogenisierte Mischung von Bi₂O₃, SrO, CaO und CuO im stöchiometrischen Verhältnis 2 : 2 : 1 : 2 wurde in einem geschlossenen Röhrenofen unter Argonatmosphäre mit 300°C/h auf eine Temperatur von 770°C aufgeheizt und 12 Stunden bei dieser Temperatur belassen. Dann wurde das Argon durch einen kräftigen Luftstrom verdrängt und die Temperatur auf 815°C erhöht. Unter Hindurchblasen eines geringen Luftstromes wurde diese Temperatur 36 Stunden aufrechterhalten. Schließlich wurde der Ofen abgeschaltet und das Reaktionsprodukt bei einer Temperatur von weniger als 200°C dem Ofen entnommen.

Das Röntgendiagramm des Reaktionsproduktes (vergl. Figur 1) weist neben der gewünschten Zweischichtphase weitere Phasen auf: Die Einschichtphase Bi₂Sr₍₂₋ₓ₎CaₓCuO₆, ein Erdalkalicuprat Sr_{(1-y)}Ca_{y}CuO₂, ein Erdalkalibismutat Sr_{(3-z)}Ca_{z}Bi₂O₆ und Kupfer(II)oxid.

### Beispiel 2 (gemäß der Erfindung)

Beispiel 1 wurde mit der Änderung wiederholt, daß in der intensiv homogenisierten Mischung das Kupfer in Form von CuO und Cu₂O im Gewichtsverhältnis 1 : 1 enthalten war.

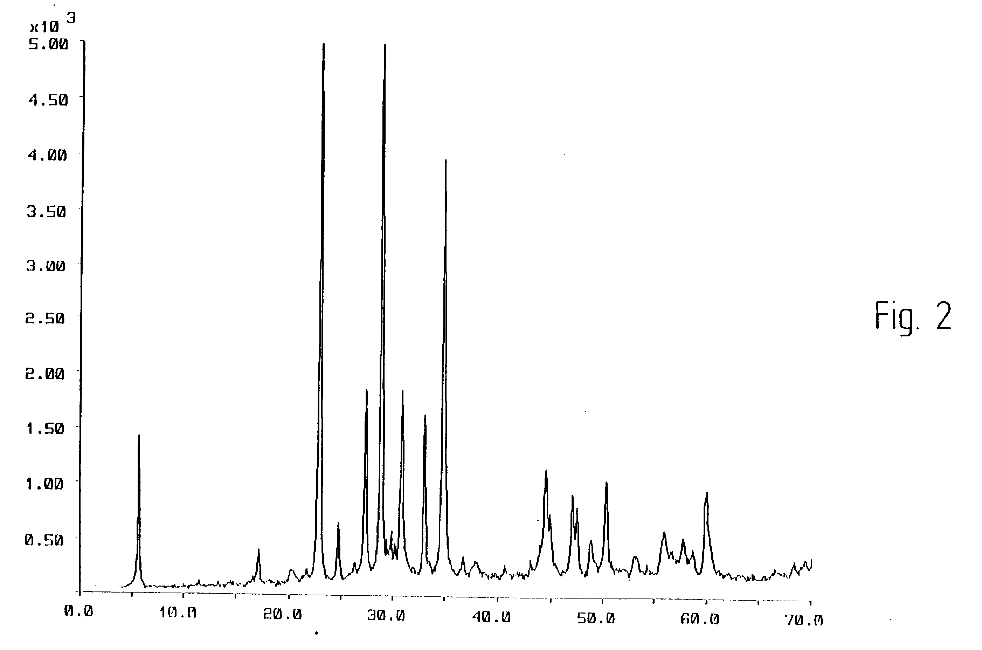

Ausweislich des Röntgendiagrammes des Reaktionsproduktes (vergl. Figur 2) ist praktisch nur die Zweischichtphase (Phasenreinheit: 95 %) entstanden.

### Beispiel 3 (Vergleich)

Eine intensiv homogenisierte Mischung von Bi₂O₃, SrO, CaO und CuO im stöchiometrischen Verhältnis 2 : 2 : 1 : 2 wurde in einem geschlossenem Röhrenofen unter Stickstoffatmosphäre mit 250°C/h auf eine Temperatur von 750°C aufgeheizt und 12 Stunden bei dieser Temperatur belassen. Dann wurde der Stickstoff durch einen kräftigen Luftstrom verdrängt und die Temperatur auf 850°C erhöht. Unter Hindurchblasen eines geringen Luftstromes wurde diese Temperatur 36 Stunden aufrechterhalten. Schließlich wurde der Ofen abgeschaltet und das Reaktionsprodukt bei einer Temperatur unterhalb von 200°C dem Ofen entnommen.

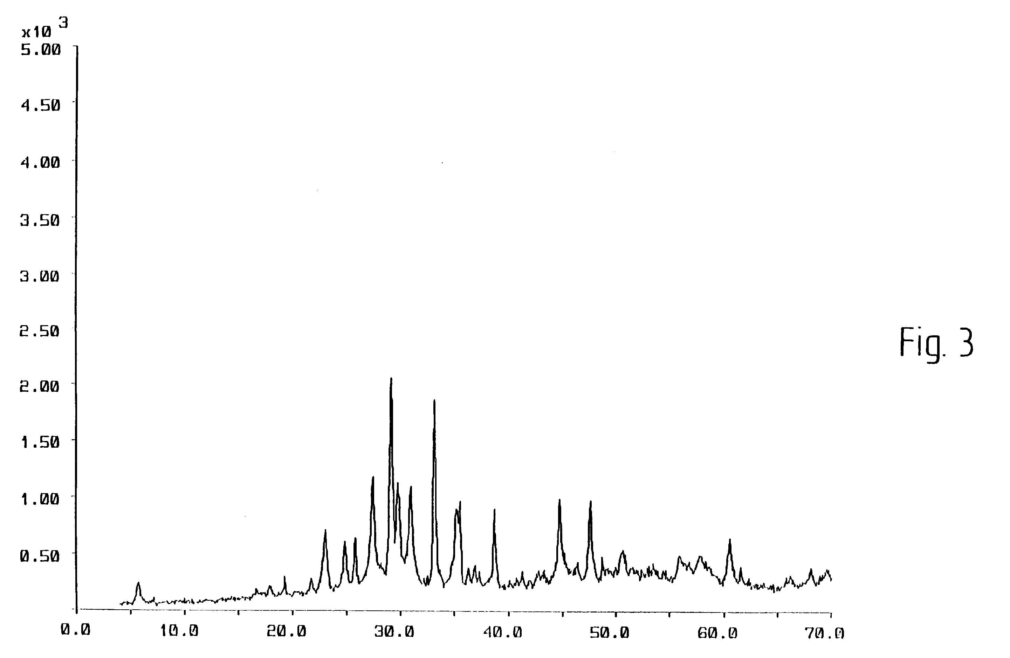

Das Röntgendiagramm des Reaktionsproduktes (vergl. Figur 3) zeigt, daß ein mehrphasiges Gemisch vorliegt, in welchem die Zweischichtphase nur in untergeordneter Menge enthalten ist.

### Beispiel 4 (gemäß der Erfindung)

Beispiel 3 wurde mit der Änderung wiederholt, daß in der intensiv homogenisierten Mischung das Kupfer in Form von CuO und Cu₂O im Gewichtsverhältnis 1,25 : 0,75 enthalten war.

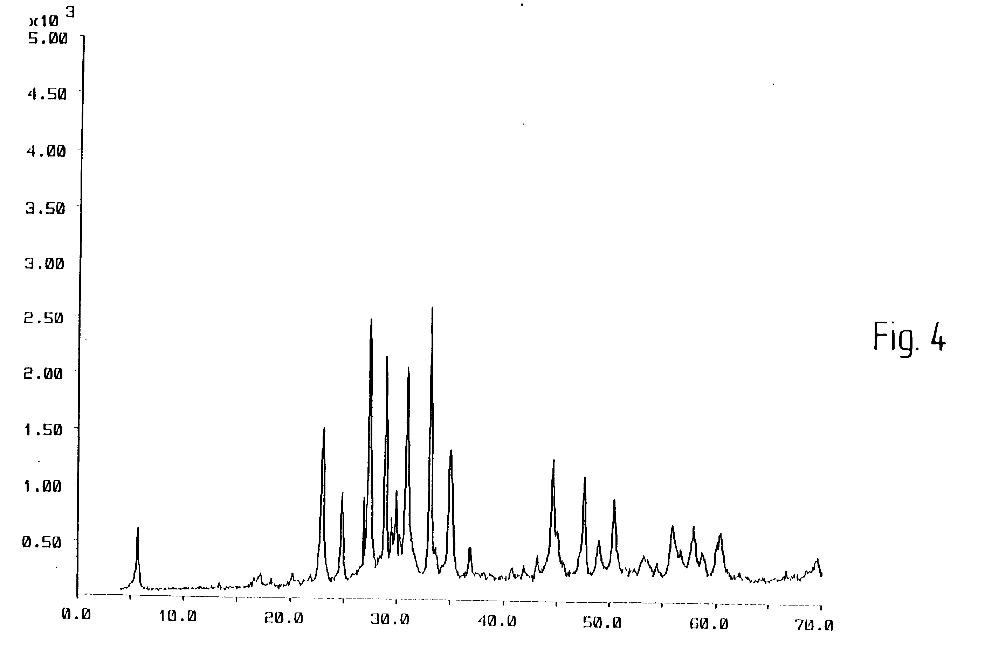

Nach dem Röntgendiagramm (vergl. Figur 4) besteht das Reaktionsprodukt praktisch nur aus der phasenreinen Zweischichtverbindung.

### Beispiel 5 (gemäß der Erfindung)

Beispiel 4 wurde mit der Änderung wiederholt, daß anstelle des geringen Luftstromes 24 Stunden bei 850°C ein reiner Sauerstoffstrom (1 bar) durch den Röhrenofen hindurchgeblasen wurde.

Das Röntgendiagramm des Reaktionsproduktes entspricht dem gemäß der Figur 4.

### Beispiel 6 (Vergleich)

Beispiel 4 wurde mit der Änderung wiederholt, daß der erste Teilschritt der Reaktion nicht unter Stickstoffatmosphäre, sondern in Luft durchgeführt wird.

Gemäß Röntgendiagramm entsteht dabei ein vielphasiges Gemisch mit einem CuO-Anteil.

## Patentansprüche

1. Verfahren zur Herstellung eines Hochtemperatursupraleiters der Zusammensetzung Bi₍₂₊ₐ₎(Sr_{(1-b)}Ca_{b})₍₃₋ₐ₎Cu_{(2+c)} O₍₈₊ₓ₎, wobei a von 0 bis 0,3, b von 0,1 bis 0,9 und c von 0 bis 2 betragen und x einen vom Oxidationszustand der enthaltenen Metalle abhängigen Wert hat, durch intensives Mischen der Oxide und/oder Carbonate des Bismuts, Strontiums, Calciums und Kupfers und Erhitzen dieses Gemisches, dadurch gekennzeichnet, daß man die Kupferverbindung als Mischung aus Kupfer(I)oxid und Kupfer(II)oxid einsetzt; daß man das Gemisch zunächst in Inertgasatmosphäre bei Temperaturen von 700 bis 800°C 0,5 bis 36 Stunden miteinander reagieren läßt; und daß man anschließend in sauerstoffhaltiger Atmosphäre bei Temperaturen von 700 bis 875°C 3 bis 60 Stunden behandelt.

2. Verfahren nach Anspruch 1, dadurch gekennzeichnet, daß das Gewichtsverhältnis von Kupfer im Kupfer(I)oxid zu Kupfer im Kupfer(II)oxid (0,25 : 1,75) bis (1,75 : 0,25) , vorzugsweise (0,5 : 1,5) bis (1,5 : 0,5) , beträgt.

3. Verfahren nach Anspruch 1 oder 2, dadurch gekennzeichnet, daß man das Gemisch in Inertgasatmosphäre bei Temperaturen von 750 bis 780°C miteinander reagieren läßt.

4. Verfahren nach mindestens einem der Ansprüche 1 bis 3, dadurch gekennzeichnet, daß man das Gemisch in Inertgasatmosphäre 12 bis 24 Stunden miteinander reagieren läßt.

5. Verfahren nach mindestens einem der Ansprüche 1 bis 4, dadurch gekennzeichnet, daß als Inertgas Argon und/oder Stickstoff verwendet ist.

6. Verfahren nach mindestens einem der Ansprüche 1 bis 5, dadurch gekennzeichnet, daß man in sauerstoffhaltiger Atmosphäre bei Temperaturen von 810 bis 860°C behandelt.

7. Verfahren nach mindestens einem der Ansprüche 1 bis 6, dadurch gekennzeichnet, daß als sauerstoffhaltige Atmosphäre Luft dient.

## Claims

1. A process for producing a high-temperature superconductor of the composition Bi₍₂₊ₐ₎(Sr_{(1-b)}Ca_{b})₍₃₋ₐ₎C_{(2+c)}O₍₈₊ₓ₎, where a is from 0 to 0.3, b is from 0.1 to 0.9 and c is from 0 to 2, and x has a value which depends on the oxidation state of the metals contained, by thoroughly mixing the oxides and/or carbonates of bismuth, strontium, calcium and copper and heating this mixture, which comprises using the copper compound as a mixture of copper(I) oxide and copper(II) oxide, allowing the mixture first to react mutually in an inert gas atmosphere at temperatures from 700 to 800°C for 0.5 to 36 hours, and subsequently treating the mixture in an oxygen-containing atmosphere at temperatures from 700 to 875°C for 3 to 60 hours.

2. The process as claimed in claim 1, wherein the weight ratio of copper in the copper(I) oxide to copper in the copper(II) oxide is (0.25:1.75) to (1.75:0.25), preferably (0.5:1.5) to (1.5:0.5).

3. The process as claimed in claim 1 or 2, wherein the mixture is allowed to react mutually in an inert gas atmosphere at temperatures from 750 to 780°C.

4. The process as claimed in at least one of claims 1 to 3, wherein the mixture is allowed to react mutually in an inert gas atmosphere for 12 to 24 hours.

5. The process as claimed in at least one of claims 1 to 4, wherein argon and/or nitrogen is used as the inert gas.

6. The process as claimed in at least one of claims 1 to 5, wherein treatment is carried out in an oxygen-containing atmosphere at temperatures from 810 to 860°C.

7. The process as claimed in at least one of claims 1 to 6, wherein air is used as the oxygen-containing atmosphere.

## Revendications

1. Procédé de préparation d'un supraconducteur à haute température de composition Bi₍₂₊ₐ₎(Sr_{(1-b)}Ca_{b})₍₃₋ₐ₎Cu_{(2+c)}O₍₈₊ₓ₎, où a vaut de 0 à 0,3, b de 0,1 à 0,9 et c de 0 à 2 et x a une valeur dépendante de l'état d'oxydation des métaux contenus, par mélange intime des oxydes et/ou carbonates de bismuth, strontium, calcium et cuivre et chauffage de ce mélange, caractérisé en ce qu'on utilise le composé du cuivre sous forme d'un mélange d'oxyde de cuivre (I) et d'oxyde de cuivre (II) ; qu'on fait tout d'abord réagir le mélange dans une atmosphère de gaz inerte à des températures comprise entre 700 et 800°C pendant, de 0,5 à 36 h ; et qu'on le traite ensuite dans une atmosphère contenant de l'oxygène à des températures comprises entre 700 et 875°C, pendant 3 à 60 h.

2. Procédé selon la revendication 1, caractérisé en ce que le rapport pondéral du cuivre sous forme d'oxyde de cuivre (I) par rapport à l'oxyde de cuivre (II) vaut de (0,25:1,75) à (1,75:0,25), de préférence de (0,5:1,5) à (1,5:0,5).

3. Procédé selon la revendication 1 ou 2, caractérisé en ce qu'on fait réagir le mélange sous atmosphère de gaz inerte à des températures comprises entre 750 et 780°C.

4. Procédé selon au moins l'une des revendications 1 à 3, caractérisé en ce qu'on fait réagir le mélange sous atmosphère inerte pendant 12 à 24 h.

5. Procédé selon au moins l'une des revendications 1 à 4, caractérisé en ce qu'on utilise, en tant que gaz inerte, de l'argon et/ou de l'azote.

6. Procédé selon au moins l'une des revendications 1 à 5, caractérisé en ce qu'on effectue le traitement dans une atmosphère contenant de l'oxygène à des températures comprises entre 810 et 860°C.

7. Procédé selon l'une au moins des revendications 1 à 6, caractérisé en ce qu'on utilise l'air en tant qu'atmosphère contenant de l'oxygène.
